# EUROPEAN PATENT SPECIFICATION

(11) **EP 0 884 788 B1**
(45) Date of publication and mention of the grant of the patent: **22.10.2003**
(21) Application number: 98304664.0
(22) Date of filing: 12.06.1998
(51) Int. Cl.: H01L 39/24

(54) **Superconducting device**
Supraleitendes Bauelement
Dispositif supraconducteur

(30) Priority: 12.06.1997 JP 15555497
(43) Date of publication of application: 16.12.1998
(73) Proprietor: KABUSHIKI KAISHA TOSHIBA, Kawasaki-shi, Kanagawa 212-8572 (JP); ISHIKAWAJIMA-HARIMA JUKOGYO KABUSHIKI KAISHA, Chiyoda-ku Tokyo 100 (JP); INTERNATIONAL SUPERCONDUCTIVITY TECHNOLOGY CENTER, Tokyo 105 (JP)
(72) Inventor: Saba, Francis Minoru, Machida-shi, Tokyo (JP); Shiohara, Yuh, Chigasaki-shi, Kanagawa-ken (JP); Enomoto, Yoichi, Tokyo (JP); Goodilin, Evgeny A., Moscow 117234 (RU); Tagami, Minoru, Yokohama-shi, Kanagawa-ken (JP)
(74) Representative: Waldren, Robin Michael

(56) References cited:
- EP-A- 0 533 568
- US-A- 5 232 900
- UTZ B ET AL: "Deposition of YBCO and NBCO films on areas of 9 inches in diameter" PROCEEDINGS OF THE 1996 APPLIED SUPERCONDUCTIVITY CONFERENCE. PART 2 (OF 3);PITTSBURGH, PA, USA AUG 25-30 1996, vol. 7, no. 2 part 2, 25 August 1996, pages 1272-1277, XP002076523 IEEE Trans Appl Supercond;IEEE Transactions on Applied Superconductivity; Materials June 1997 IEEE, Piscataway, NJ, USA

## Description

The present invention relates to a superconducting device and, more particularly, to a superconducting device in which an underlying or interlevel insulating layer is improved.

In an integrated circuit device using a high-temperature oxide superconductor, for example, a SQIUD for low-magnetic field detection, SrTiO₃ is conventionally used as an interlevel insulating film at a portion where the wires of the input coils intersect. Since SrTiO₃ has a high relative permittivity, a high-speed switching circuit device using this material undesirably suffers a high dielectric loss.

To solve this problem, for example, MgO can be used as a material having a lower relative permittivity in the interlevel insulating layer. MgO, however, disturbs the crystal structure of the oxide superconductor constituting the wire, thereby degrading the device characteristics. If the crystal structure of the oxide superconductor is disturbed, a parasitic Josephson junction or resistance, which does not exist in the design stage, may be introduced into the circuit.

It is an object of the present invention to provide a superconducting device having an underlying or interlevel insulating layer capable of suppressing a dielectric loss even in a high-speed switching operation without disturbing the crystal structure of a wire made of an oxide superconductor.

EP 0 533 568 discloses a superconducting thin film formed on a substrate, comprising at least one oxide superconductor layer formed on the principal surface of the substrate, and at least one oxide layer arranged on or under the superconducting layer. The purpose of the insulating layer is to allow the superconducting film to have an ultra thin thickness.

A superconducting device according to the present invention comprises a superconducting wire (3, 5) made of an oxide superconductor represented by REBa₂Cu₃O_{7-δ} where RE is at least one element selected from the group consisting of Y and rare-earth elements, formed on an underlying or interlevel insulating layer (2, 4), characterized in that the underlying or interlevel insulating layer (2, 4) consists of a material represented by Pr₁₊ₓBa₂₋ₓCu₃O_{7-δ} where δ ranges from 0.4 to 1.0 and x ranges from 0.1 to 0.3, or Nd₂₋ₓBa₁₊ₓCu₃O₇ where x ranges from 0.1 to 0.1.

This invention can be more fully understood from the following detailed description when taken in. conjunction with the accompanying drawings, in which:
FIG. 1 is a perspective view of a superconducting device according to the present invention;
FIG. 2 is a graph showing the dielectric characteristics of Pr₁₊ₓBa₂₋ₓCu₃O_{7-δ} (x = 0.14) at 97.58K; and
FIG. 3 is a graph showing the dielectric characteristics of Nd₂₋ₓBa₁₊ₓCu₃O₇ (x = 0.1) at 4.2K.

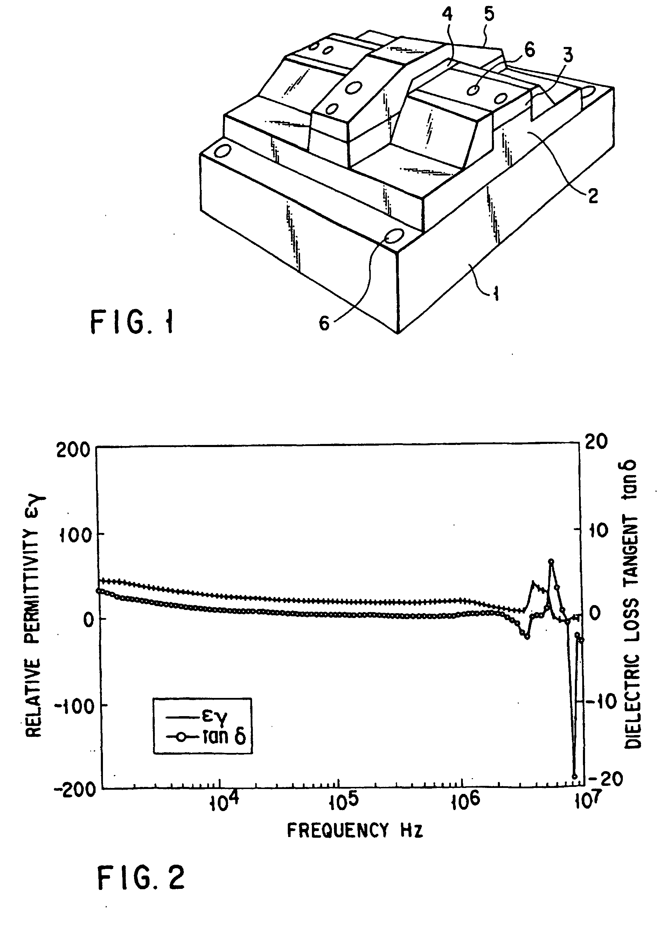

An example of a superconducting device according to the present invention is shown in FIG. 1.

Referring to FIG. 1, on a substrate 1 made of, e.g., YBCO single crystal, formed are an underlying insulating layer 2, a superconducting wire 3 made of an oxide superconductor, an interlevel insulating layer 4, and a superconducting wire 5 made of an oxide superconductor. Electrodes 6 made of, e.g., Au are formed on the substrate 1 and the superconducting wires 3 and 5.

This superconducting device can be manufactured as follows. An underlying insulating layer 2 is deposited on a substrate 1, and a superconducting layer serving as a superconducting wire 3 is deposited on the insulating layer 2. A wire pattern is formed by exposing and developing a resist by photolithography. The superconducting layer is etched with an Ar ion milling apparatus using the resist as a mask to form a superconducting wire 3. A thin film serving as an interlevel insulating layer 4 is deposited, and a superconducting layer serving as a superconducting wire 5 is deposited on the insulating layer 4. A wire pattern is formed by exposing and developing a resist using photolithography. The superconducting layer is etched with the Ar ion milling apparatus using the resist as a mask to form a superconducting wire 5. Electrodes 6 for electrical characteristic measurement are finally deposited by a sputtering apparatus.

A surface-polished c-axis oriented YBCO, SrTiO₃, or NdGaO₃ single-crystal substrate is used as the substrate 1.

As the oxide superconductor constituting the superconducting wires 3 and 5, a REBa₂Cu₃O_{7-δ} oxide superconductor such as NdBa₂Cu₃O_{7-δ}(NBCO) or YBa₂Cu₃O_{7-δ}(YBCO) may be used. The oxygen deficiency δ of the oxide superconductor is set to fall within the range which does not impair the superconducting characteristics, and generally set in the range of 0 to about 0.5. An NBCO film is formed by off-axis sputtering under the conditions, for example, that the substrate temperature is set to 840°C, and the pressure in the sputtering apparatus is set to 10Pa (80 mTorr) with a gas mixture of oxygen/Ar (1/4), and 60-W rf power is applied to an NBCO target. After the film deposition, the heater is turned off, and the pressure in the sputtering apparatus is set to 53kPa (400 Torr) with the gas mixture of oxygen/Ar (1/3) to quench the sample. In case of a YBCO film, the substrate temperature is set to, e.g., 740°C. The deposition rate is about 2.7nm/min (27 Å/ min). The critical temperature T_{C} of the superconducting thin film formed by this method. normally falls within the range of 80 to 90K.

To suppress a tunnel current between the superconducting wires 3 and 5, the thickness of the interlevel insulating layer 4 is set to fall within the range of about 100 to 500 nm.

To reduce a dielectric loss and attain good insulating properties, the underlying or interlevel. insulating layer must have a resistivity of 10² Ω·cm or more and preferably 10⁴ Ω·cm or more, and a relative permittivity of 30 or less at an operating temperature of 77K or less.

In the present invention, the underlying insulating layer 2 and/or the interlevel insulating layer 4 is made of a material represented by the following formula:

Pr₁₊ₓBa₂₋ₓCu₃O_{7-δ}

where x ranges from 0.1 to 0.3 and 6 ranges from 0.4 to 1.0, resistivity of which increases as x comes close to 0.3 at low temperatures, or

Nd₂₋ₓBa₁₊ₓCu₃O₇

where x ranges 0.1 to 0.4, in which an excess or deficiency of oxygen in the range without impairing the insulating properties is permitted.

The crystal structure of these insulators resembles that of an oxide superconductor NBCO or YBCO. For this reason, the REBa₂Cu₃O_{7-δ} superconductor formed on such an insulator is likely to grow epitaxially.

The above Pr-based material exhibits excellent characteristics as the underlying or interlevel insulating layer when x falls within the range of 0.1 to 0.3 and δ falls within the range of 0.4 to 1.0. However, when both x and δ have values smaller than the lower limits of the above ranges, the resistance becomes excessively low, resulting in a poor underlying or interlevel insulating layer. As for the Nd-based material, when x exceeds 0.4, it exhibits superconducting characteristics and has a low resistance, resulting in a poor underlying or interlevel insulating layer.

### Examples

Examples using Pr₁₊ₓBa₂₋ₓCu₃O_{7-δ} (δ ranges from 0.4 to 1) for the underlying and interlevel insulating layers 2 and 4 will be described below. The deposition conditions are as follows.

A substrate and a Pr₁₊ₓBa₂₋ₓCu₃O_{7-δ} (x = 0.14) target were set in an rf sputtering apparatus. The substrate temperature was set to 740°C (preferably 700°C to 850°C), and a gas mixture of oxygen/Ar was supplied to the apparatus at a flow rate ratio of 5.5 : 0.7 [sccm] (preferably 5.0 to 6.0 : 0.5 to 1.0 [sccm]). The pressure in the sputtering apparatus was set to 10Pa (80 mTorr) (preferably 9 to 12Pa (70 to 90 mTorr)). RF power of 40W was supplied to the target to deposit a thin film on the substrate by off-axis sputtering. The deposition rate was about 0.7nm/min (7 Å/min). After the film deposition, the heater was turned off, and Ar gas was supplied to the apparatus to set the pressure to 53kPa (400 Torr). In this state, the sample was quenched. The cooling rate in the initial quenching stage was about 1 °C/s and about 1 °C/min at about 200°C. The substrate was quenched to 70°C over about 70 to 90 min.

The temperature dependency of the resistivity was measured. The resultant thin film exhibited semiconductor characteristics and high resistance at 100K or less. More specifically, the resistivity was 10 Ω·cm at 97.58K, 10² Ω · cm at 77K, and 10⁴ Ω · cm at 40K.

FIG. 2 shows the dielectric characteristics of Pr₁₊ₓBa₂₋ₓCu₃O_{7-δ} (x = 0.14) at 97.58K. Although not shown, the relative permittivity of this material exceeds 6,000 under a frequency of 100 kHz at room temperature. As shown in FIG. 2, the relative permittivity εᵣ and the dielectric loss tangent tanδ are 23 or less and 0.3 or less, respectively, under a frequency of 100 kHz at a temperature of 97.58K. The frequency dependency of the relative permittivity can be substantially neglected. At lower temperatures, the relative permittivity ε ᵣ has smaller values, and the frequency dependency of the relative permittivity can be substantially neglected.

A thin film was formed on a substrate using a Pr₁₊ₓBa₂₋ₓCu₃O_{y} (x = 0.3) target under the same conditions as described above. As for the thin film having x of 0.3, the resistivity at 98K was about 100 times as high as that of the thin film having x of 0.14, and the dielectric loss tangent tanδ was 0.01 or less, while the relative permittivity was approximately equal to that of the thin film having x of 0.14.

Similarly, an example using Nd₂₋ₓBa₁₊ₓCu₃O₇ for the underlying insulating layer 2 and the interlevel insulating layer 4 will be described below. The deposition conditions are as follows.

A substrate and an Nd₂₋ₓBa₁₊ₓCu₃O₇ (x = 0.1) target were set in an rf sputtering apparatus. The substrate temperature was set to around 950°C to 1,000°C, and a gas mixture of oxygen/Ar was supplied to the apparatus at a flow rate ratio of 5.0 to 6.0 : 0.6 to 0.8 [sccm] to set the pressure in the sputtering apparatus to 10 to 13Pa (80 to 100 mTorr). RF power of 60W was supplied to the target to deposit a thin film on the substrate by off-axis sputtering. After the film deposition, the heater was turned off, and 100% oxygen gas was supplied to the apparatus to set the internal pressure to 53kPa (400 Torr). In this condition, the sample was quenched.

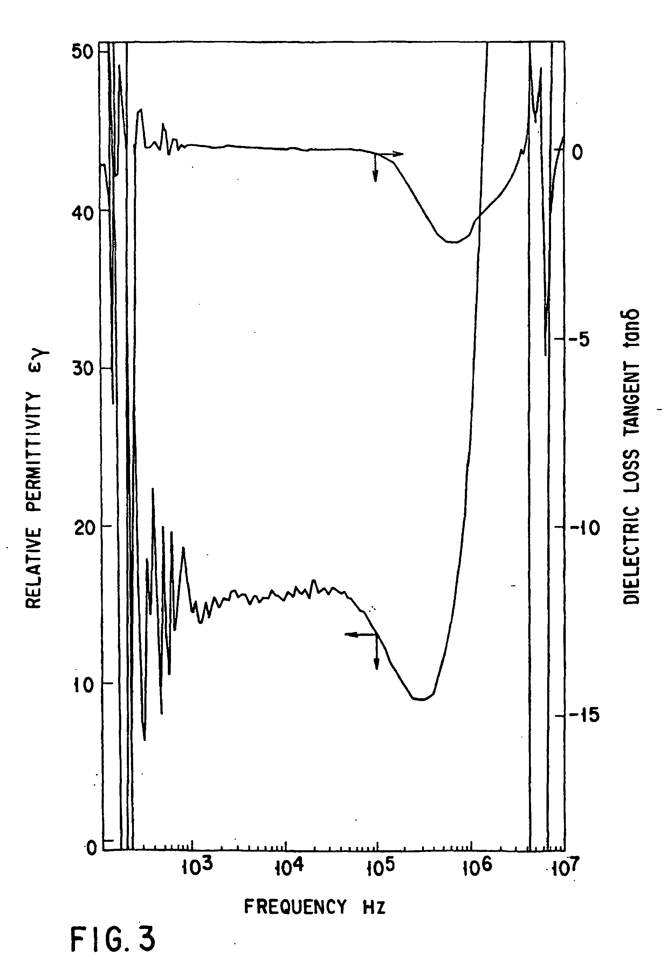

FIG. 3 shows the dielectric characteristics of Nd₂₋ₓBa₁₊ₓCu₃O₇ (x = 0.1) at 4.2K. At the temperature of 4.2K, the relative permittivity εᵣ and the dielectric loss tangent tanδ were approximately 13 and zero, respectively, under a frequency of 100 kHz.

## Claims

1. A superconducting device comprising a superconducting wire (3, 5) made of an oxide superconductor represented by
REBa₂Cu₃O_{7-δ}
where RE is at least one element selected from the group consisting of Y and rare-earth elements, formed on an underlying or interlevel insulating layer (2, 4),
**characterized in that** the underlying or interlevel insulating layer (2, 4) consists of a material represented by
Pr₁₊ₓBa₂₋ₓCu₃O_{7-δ}
where δ ranges from 0.4 to 1.0 and x ranges from 0.1 to 0.3, or
Nd₂₋ₓBa₁₊ₓCu₃O₇
where x ranges from 0.1 to 0.4.

2. The device according to claim 1, **characterized in that** the underlying or interlevel insulating layer (2, 4) has a resistivity of not less than 10²Ω·cm and a relative permittivity of not more than 30 at a temperature of not more than 77K.

3. The device according to claim 1, **characterized in that** said underlying or interlevel insulating layer (2, 4) has a resistivity of not less than 10⁴Ω·cm at a temperature of not more than 77K.

4. The device according to claim 1, **characterized in that** said interlevel insulating layer (4) has a thickness falling within a range of 100 to 500 nm.

## Patentansprüche

1. Supraleitende Vorrichtung, umfassend einen supraleitenden Draht (3, 5), hergestellt aus einem oxidischen Supraleiter, dargestellt durch
REBa₂Cu₃O_{7-δ}
worin RE zumindest ein Element ist, welches ausgewählt ist aus der Gruppe, bestehend aus Y und Seltenerdelementen, gebildet auf einer darunterliegenden oder zwischen den Ebenen liegenden isolierenden Schicht (2, 4),
**dadurch gekennzeichnet, dass** die darunterliegende oder zwischen den Ebenen liegende isolierende Schicht (2, 4) aus einem Material besteht, das repräsentiert wird durch
Pr₁₊ₓBa₂₋ₓCu₃O_{7-δ}
worin δ im Bereich von 0,4 bis 1,0 liegt und x im Bereich von 0,1 bis 0,3 liegt, oder
Nd₂₋ₓBa₁₊ₓCu₃O₇
worin x im Bereich von 0,1 bis 0,4 liegt.

2. Vorrichtung gemäss Anspruch 1, **dadurch gekennzeichnet, dass** die darunterliegende oder zwischen den Ebenen liegende isolierende Schicht (2, 4) einen spezifischen Widerstand von nicht weniger als 10² Ω·cm und eine relative Dielektrizitätskonstante von nicht mehr als 30 bei einer Temperatur von nicht mehr als 77 K aufweist.

3. Vorrichtung gemäss Anspruch 1, **dadurch gekennzeichnet, dass** die darunterliegende oder zwischen den Ebenen liegende isolierende Schicht (2, 4) einen spezifischen Widerstand von nicht weniger als 10⁴ Ω·cm bei einer Temperatur von nicht mehr als 77 K aufweist.

4. Vorrichtung gemäss Anspruch 1, **dadurch gekennzeichnet, dass** die zwischen den Ebenen liegende isolierende Schicht (4) eine innerhalb des Bereichs von 100 bis 500 nm liegende Dicke aufweist.

## Revendications

1. Dispositif supraconducteur comprenant un fil supraconducteur (3, 5) fait d'un supraconducteur du type oxyde, représenté par :
REBa₂Cu₃O_{7-δ}
où RE désigne au moins un élément choisi dans le groupe constitué de Y et d'éléments des terres rares, formé sur une couche isolante sous-jacente ou intermédiaire (2, 4),
**caractérisé en ce que** la couche isolante sous-jacente ou intermédiaire (2, 4) est constituée d'un matériau représenté par :
Pr₁₊ₓBa₂₋ₓCu₃O_{7-δ}
où δ est compris entre 0,4 et 1,0 et x est compris entre 0,1 et 0,3 ou bien
Nd₂₋ₓBa₁₊ₓCu₃O₇
où x est compris entre 0,1 et 0,4.

2. Dispositif selon la revendication 1, **caractérisé en ce que** la couche isolante sous-jacente ou intermédiaire (2, 4) possède une résistivité qui n'est pas inférieure à 10² Ω.cm et une permitivité relative qui n'est pas supérieure à 30 à une température ne dépassant pas 77 K.

3. Dispositif selon la revendication 1, **caractérisé en ce que** ladite couche isolante sous-jacente ou intermédiaire (2, 4) possède une résistivité qui n'est pas inférieure à 10⁴ Ω.cm à une température ne dépassant pas 77 K.

4. Dispositif selon la revendication 1, **caractérisé en ce que** ladite couche isolante intermédiaire (4) possède une épaisseur qui se trouve à l'intérieur de l'intervalle de 100 à 500 nm.
